# EUROPEAN PATENT SPECIFICATION

(11) **EP 4 677 744 B1**
(45) Date of publication and mention of the grant of the patent: **25.11.2026**
(21) Application number: 24707061.8
(22) Date of filing: 27.02.2024
(51) Int. Cl.: H03F 3/08, H03F 1/26, H03F 3/45

(54) **IMPROVED BANDWIDTH FOR LARGE PHOTODIODE RECEIVER IN LIFI SYSTEMS**
VERBESSERTE BANDBREITE FÜR EMPFÄNGER MIT GROSSEN PHOTODIODEN IN LIFI-SYSTEMEN
LARGEUR DE BANDE AMÉLIORÉE POUR RÉCEPTEUR À PHOTODIODE DE GRANDE TAILLE DANS DES SYSTÈMES LIFI

(30) Priority: 10.03.2023 EP 23161289
(43) Date of publication of application: 14.01.2026
(73) Proprietor: Signify Holding B.V., 5656 AE Eindhoven (NL)
(72) Inventor: LINNARTZ, Johan, Paul, Marie, Gerard, 5656 AE Eindhoven (NL); SEVO, Aleksandar, 5656 AE Eindhoven (NL)
(74) Representative: Verweij, Petronella Daniëlle
(86) International application number: PCT/EP2024/054865
(87) International publication number: WO 2024/188627

(56) References cited:
- JP-A- 2008 187 345
- JP-B2- 4 090 476
- US-A1- 2017 030 769
- US-A1- 2020 233 064
- PURYGA E A ET AL: "Broadband Signal Amplification Paths for Semiconductor Radiation and Particle Detectors (Review)", INSTRUMENTS AND EXPERIMENTAL TECHNIQUES, CONSULTANTS BUREAU. NEW YORK, US, vol. 65, no. 1, 2 February 2022 (2022-02-02), pages 29 - 41, XP037714596, ISSN: 0020-4412, [retrieved on 20220312], DOI: 10.1134/S0020441222010183
- SEUNGWOO JUNG ET AL: "A design methodology to achieve low input impedance and non-constant gain-bandwidth product in TIAs for optical communication", CIRCUITS AND SYSTEMS (ISCAS), 2013 IEEE INTERNATIONAL SYMPOSIUM ON, IEEE, 19 May 2013 (2013-05-19), pages 598 - 601, XP032445988, ISBN: 978-1-4673-5760-9, DOI: 10.1109/ISCAS.2013.6571913
- MASUDA T ET AL: "40 Gb/s analog IC chipset for optical receiver using SiGe HBTs", SOLID-STATE CIRCUITS CONFERENCE, 1998. DIGEST OF TECHNICAL PAPERS. 199 8 IEEE INTERNATIONAL SAN FRANCISCO, CA, USA 5-7 FEB. 1998, NEW YORK, NY, USA,IEEE, US, 5 February 1998 (1998-02-05), pages 314 - 315, XP032382646, ISBN: 978-0-7803-4344-3, DOI: 10.1109/ISSCC.1998.672482

## Description

### FIELD OF THE INVENTION

The invention relates to a wireless receiver for optical communication. The invention further relates to a system for optical communication.

### BACKGROUND OF THE INVENTION

In the field of wireless optical communication, the optical receiver is the most sensitive if it can capture a large amount of photons. Hence the use of large sensing surface area photodiodes are attractive. However, photodiodes with such a large sensing surface area have also a larger parasitic capacitance due to their increase in surface. This parasitic capacitance limits the bandwidth of the signal generated by the photodiode. One may use a lens to focus the light power onto a small spot, but as the signal may come over a range of angles, such imaging detector nonetheless requires a large surface area. A transimpedance amplifier, TIA, can repair the bandwidth of the signal, but these have the disadvantage that it boosts the noise at high frequencies. A cascoded transimpedance amplifier can be provided to reduce boosting of the noise. However, noise still persists. It is desired to provide a solution that further reduces the noise while keeping a high sensitivity. JP 2008 187345 A (NEC ELECTRONICS CORP) 14 August 2008 (2008-08-14) discloses a similar wireless receiver.

### SUMMARY OF THE INVENTION

It is an objective of the invention to provide a circuit that allows an improved sensitivity while maintaining a good noise reduction.

To provide a solution, in a first aspect of the invention, a wireless receiver for optical communication is provided. The wireless receiver comprises:
- a first photodiode;
- a first semiconductor switching element comprising a first connection and a second connection, wherein the first connection of the first semiconductor switching element is coupled to an output of the first photodiode;
- a second photodiode;
- a second semiconductor switching element comprising a first connection and a second connection, wherein the first connection of the second semiconductor switching element is coupled to an output of the second photodiode;
- a transimpedance amplifier, TIA, comprising a first input, wherein the second connection of the first semiconductor switching element and the second connection of the second semiconductor switching element are coupled to the first input of the TIA.

A first photodiode is provided. The output of the first photodiode is coupled to a first semiconductor switching element. A second photodiode is provided. The output of the second photodiode is coupled to a second semiconductor switching element. A transimpedance amplifier, TIA, is provided to enhance the bandwidth for the wireless receiver. An input of the TIA is coupled to one end of the first semiconductor switching element and one end of the second semiconductor switching element. The TIA may have a second input, which may be coupled to a reference voltage. The use of multiple photodiodes allows a larger total photodiode surface to be used. Additionally, the use of multiple smaller photodiodes instead of using a single large photodiode allows the use of measures to mitigate the impact of the capacitance and allows the selection of a subset of the photodiode area to reduce noise, interference and to reduce parasitic capacitance from sections that do not substantially contribute to the signal.

A larger capacitance has a negative impact of the bandwidth i.e., the bandwidth of the wireless receiver is limited. A TIA may be provided to further improve the bandwidth. The outputs of the photodiodes are coupled to the input of the TIA via the corresponding second semiconductor switching elements. A single TIA may be used regardless of the number of photodiodes. A drawback of the TIA is that the noise generated is also amplified. The semiconductor switching elements are used to prevent the parasitic capacitances of the photodiodes to interact with each other. In other words, the photodiodes do not 'see' each other parasitic capacitances. Therefore, their noise is not provided to the TIA and less noise will therefore be amplified. Another effect is that the use of semiconductor switching elements strongly reduces the noise generated by the TIA. In fact, a TIA operated in open loop would have an excessively strong noise at its output. The feedback strongly limits the gain of the noise. However, if the photodiodes cause a high capacitance at the TIA input, this feedback no longer effectively reduces the noise. A semiconductor switching element between photodiodes and the TIA input can be used to mitigate this, to reduce noise via feedback despite the capacitance of photodiodes. However, there are limits to the use of a single semiconductor switching element. Firstly, photodiodes nonetheless see each other's parasitic capacitance. Secondly, the wiring from all photodiodes to the common semiconductor switching element may have to be long thus create additional capacitances that affect the signal response.

The claimed invention therefore allows to have a large total sensor surface area with a high bandwidth and a low noise.

In a further example, the first semiconductor switching element is adapted to operate in a linear operating mode in which it shows a low impedance on the first connection to the first photodiode and a high impedance on the second connection to the TIA.

Using the first semiconductor switching element, and preferably also the second semiconductor switching element, in a linear operating mode allows the respective photodiode to see a low impedance at its output and the TIA sees a high impedance at its input. This allows the parasitic capacitance from the photodiodes to be isolated form the input of the TIA, while the TIA can still receive the signal provided form the photodiodes. Any noise generated by the TIA will therefore not find a conductive path through the parasitic capacitances of the photodiodes.

In a further example, the first semiconductor switching element is a bipolar transistor adapted to operate in a linear operating mode and wherein the second semiconductor switching element is a bipolar transistor adapted to operate in a linear operating mode.

In a further example, first semiconductor switching element is a bipolar transistor wherein:
- an emitter of the bipolar transistor is coupled to the first photodiode;
- a collector of the bipolar transistor is coupled to the first input of the TIA;
- a base of the bipolar transistor is coupled to a reference voltage.

In its simplest form, the first semiconductor switching element is a bipolar transistor, which preferably operates in a linear operating mode. Similar, preferably, the second semiconductor switching element is a bipolar transistor that operates in a linear operating mode. This allows the noise generated by the photodiodes to be further suppressed such that a total lower noise arrives at the input of the TIA.

In a further example, the first semiconductor switching element comprises a control connection and the second semiconductor switching element comprises a control connection, wherein the control connection of the first semiconductor switching element and the control connection of the second semiconductor switching element are coupled to the reference voltage or the control connection of the first semiconductor switching element is adapted to receive a first control signal and the control connection of the second semiconductor switching element is adapted to receive a second control signal.

Preferably, the first semiconductor switching element and the second semiconductor switching element have a control connection e.g., a base for a transistor, which may be coupled to a reference voltage. This allows a single voltage such as e.g. 0 V to be provided, which allows a simple design to be achieved.

The first semiconductor switching element and the second semiconductor switching element can also have their control connections to receive corresponding control signals. This allows regulation or controlling of the semiconductor switching elements.

In a further example, when the control connection of the first semiconductor switching element is adapted to receive the first control signal and the control connection of the second semiconductor switching element is adapted to receive the second control signal, wherein the first control signal and the second control signal are provided to couple or decouple the first photodiode and/or the second photodiode to or from the first input of the TIA.

Providing a control signal to the first and second semiconductor switching elements allows the photodiodes to be coupled to or decoupled from the input of the TIA. This allows photodiodes to be connected or disconnected allowing the sensor surface area of the wireless receiver to be altered. This may be beneficial when e.g. a directionality of the wireless receiver needs to be adapted.

In a further example, the first semiconductor switching element comprises a control connection and the second semiconductor switching element comprises a control connection, wherein the control connection of the first semiconductor switching element is adapted to receive a first control signal and the control connection of the second semiconductor switching element is adapted to receive a second control signal.

Preferably, first semiconductor switching element can be controlled via its control connection e.g., a base node, to allow the linear operating mode of the first semiconductor switching element to be regulated. Additionally, the second semiconductor switching element can be controlled via its control connection e.g., a base node, to allow the linear operating mode of the first semiconductor switching element to be regulated. By individually controlling the first semiconductor switching element and the second semiconductor switching element, additional functionality can be introduced as will be described later on.

In a further example, the first control signal and the second control signal are provided to couple or decouple the first photodiode and/or the second photodiode to the first input of the TIA.

Preferably, the control signals of the first semiconductor switching element and the second semiconductor switching element can be used to open any of the semiconductor switching elements, effectively decoupling the corresponding photodiode from the TIA. This allows more or less photodiodes to be coupled, which may allow the sensing angle of the wireless receiver to be adjusted.

In a further example, the reference voltage is a ground reference voltage.

Providing a ground reference is the simplest form of a reference and allows a relatively low noise reference to be provided. This is also often referred to as a reference voltage of 0 V. Alternatively, the reference voltage may have a voltage larger than 0 V. This allows any offset compensation when needed.

In a further example, the TIA has a second input to which a reference voltage is applied.

Preferably, the TIA has a second input that can receive a reference voltage. This allows the reference voltage to be configured as desired. Alternatively, the TIA may generate its own reference voltage and from the outside it may appear as if no second input is present.

In a further example, the TIA further comprises a third semiconductor switching element and an operational amplifier, wherein the third semiconductor is coupled between the first input of the TIA and an input of the operational amplifier and wherein the second input of the TIA is coupled to a second input of the operational amplifier.

The TIA may comprise a third semiconductor switching element and an operational amplifier, Op-Amp. The third semiconductor switching element is placed between the first input of the TIA and a first input of the Op-Amp. The third semiconductor switching element effectively provides for an electric connection between the first input of the TIA and the first input of the Op-Amp. The second input of the input is preferably connected to the second input of the Op-Amp, preferably in a direct connection. The connection between the second input of the TIA and the second input of the Op-Amp allows the refence voltage to be directly provided to the Op-Amp. Preferably, the first input of the Op-Amp is the negative input. The second input of the Op-Amp is then the positive input.

In a further example, the operational amplifier and the third semiconductor switching element are integrated on a single die or integrated in a single package.

Preferably, the function of the TIA is provided on a single die and/or in single package. This allows a simple implementation of the TIA to be provided in an electronic design. The TIA is then also preferably provided with the third semiconductor switching element and the Op-Amp.

In a further example, the first photodiode and the first semiconductor switching element are integrated on a single die or integrated in a single package.

Preferably, the first photodiode and the first semiconductor switching element are integrated on a single die and/or integrated in a single package. This allows a modular build up of the wireless receiver as multiple similar components can be used for enlarging the total photodiode surface area while automatically allowing the improved effects of the invention to be achieved.

In a further example, the third semiconductor switching element is a bipolar transistor adapted to operate in a linear operating mode.

Similar as for the first semiconductor switching element and the second semiconductor switching element, the third semiconductor switching element is also a bipolar transistor that operates in a linear operating mode.

In another example, a system for optical communication is provided. The system for optical communication comprises:
- a wireless receiver according to any of the preceding examples;
- a driver adapted to receive an input power at an input of the driver and provide a regulated output power at an output of the driver;
- a load coupled to the output of the driver.

Preferably, the wireless receiver forms part of a system for optical communication. In this system, the wireless, optical, communication may be used for regulating a load. A driver may be used for powering the load. The optical communication can be used for receiving control information required by the driver for controlling the load. Alternatively, the optical communication can be used for setting up a communication link between two device such as in a light fidelity, LiFi, network.

In another example, the load is a lighting load and wherein the system is a lighting system.

Preferably, the load is a lighting load since the lighting load may be well suited for providing optical communication. Additionally, the lighting load may be used for providing general illumination. The optical communication is then for example not visible for the human eye and is therefore arranged such that the quality of the general illumination is not impacted by the optical communication. In this example, the system may be a lighting system such as a lamp or a luminaire.

In another example, the lighting load comprises a semiconductor lighting element.

Preferably, the lighting load has a semiconductor lighting element. Examples of semiconductor lighting elements are LEDs, laser diodes and vertical-cavity surface-emitting lasers. Semiconductor lighting element are capable of providing high frequency light pulses that allow high bandwidth communication.

In another example, the regulated output power is controlled based on information received by the wireless receiver.

The optical communication can be used to provide information to the system by another optical communication system. This allows wireless control of the light sources to be provided without providing undesired radiofrequency radiation. An advantage of optical communication is that the use of a photodiode does not require an antenna, which may provide challenges in positioning.

### BRIEF DESCRIPTION OF THE DRAWINGS

Examples of the invention will now be described with reference to the accompanying drawings, in which:
Fig. 1 shows an example of a circuit diagram of a wireless receiver.
Fig. 2 shows another example of a circuit diagram of a wireless receiver.
Fig. 3 shows another example of a circuit diagram of a wireless receiver.
Fig. 4 shows another example of a circuit diagram of a wireless receiver.
Fig. 5 shows another example of a circuit diagram of a wireless receiver.
Fig. 6 shows another example of a circuit diagram of a wireless receiver.
Fig. 7 shows another example of a circuit diagram of a wireless receiver.
Fig. 8 shows another example of a circuit diagram of a wireless receiver.
Fig. 9 shows an example of a circuit diagram of a system for optical communication.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should also be understood that the Figures are merely schematic and are not drawn to scale. It should also be understood that the same reference numerals are used throughout the Figures to indicate the same or similar parts.

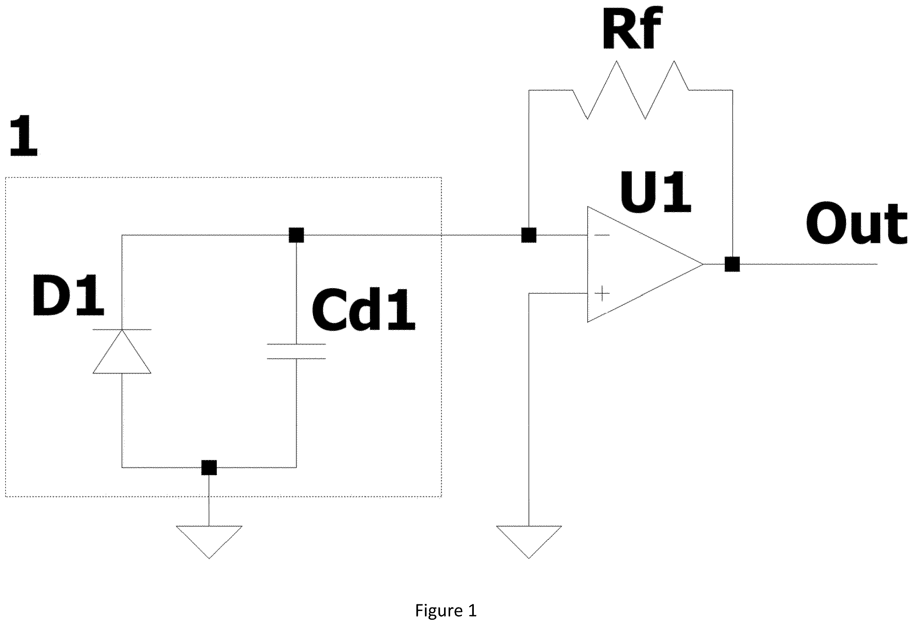

Figure 1 shows an example of a wireless receiver 4 having a photodiode 1 that is coupled to a TIA. The TIA has an Op-Amp U1 and a feedback resistor Rf, coupled between the negative input of the Op-Amp and the output of the Op-Amp. For simplicity, the photodiode is coupled between the negative input of the Op-Amp and a ground reference. Instead of the ground reference, the photodiode may be provided with a bias voltage. The photodiode 1 has a diode D1 that receives light and generates a corresponding signal. The photodiode 1 also has a parasitic capacitance Cd1, which is electrically represented as a capacitor in parallel with the diode D1. The parasitic capacitance Cd1 causes the bandwidth of the wireless receiver 4 to be reduced. The TIA is used to improve the bandwidth of the wireless receiver. The Op-Amp U1 provides a feedback current such that a voltage difference between the positive input and the negative input is zero. The positive input is coupled to ground. The output of the Op-Amp U1 will therefore provide a current via the feedback resistor Rf to the negative input such that the voltage at the negative input is in good approximation equal to the voltage at the positive input, particularly if the gain of the Op-Amp is large. In this example, the Op-Amp U1 will regulate the voltage at the negative input to be at the ground level, which is 0 V. The parasitic capacitance Cd1 therefore receives a ground voltage at both nodes and is therefore considered shunted, while coupled to ground. The diode D1 provides a current depending on the light signal received. The current can not flow to the parasitic capacitance Cd1 and is therefore in its entirety provided to the TIA. The current provided by the diode D1 is translated by the Op-Amp U1 and feedback resistor Rf into a voltage at the output of the Op-Amp U1. The TIA is therefore well suited for compensating for any parasitic capacitance Cd1 provided by the photodiode 1.

Using the TIA as shown in Figure 1 will result in an undesired effect. The Op-Amp U1 inherently generates noise, which can be represented as a noise voltage source Vn, not shown here, at the positive input of the Op-Amp U1. This noise voltage can be interpreted as if it creates an offset at the positive input of the Op-Amp U1 and therefore has the effect that it would generate an error between the positive input and the negative input. Although the noise voltage may be of a very low amplitude, the gain of the Op-Amp U1 may amplify the voltage to a noticeable undesired voltage at the output of the Op-Amp U1. The gain of the noise signal is determined by the feedback attenuation, thus by the ratio of the impedance (capacitance) of the photodiode 1 and the feedback resistor Rf.

The noise, in particularly the high frequency components do not see an effective feedback because the capacitance of the photodiode short-circuits to ground the feedback signal via feedback resistor Rf. Therefore, the high frequency components are highly amplified by the Op-Amp gain, without mitigation by feedback.

A high frequency current is provided via the feedback resistor Rf to the negative input. The parasitic capacitance Cd1 behaves as a low impedance for the high frequency current provided by the output of the Op-Amp U1. The current will therefore flow through the parasitic capacitance, effectively causing an undesired voltage drop across the feedback resistor Rf and results therefore in a change in the output voltage, which is represented as an amplified noise on the output voltage.

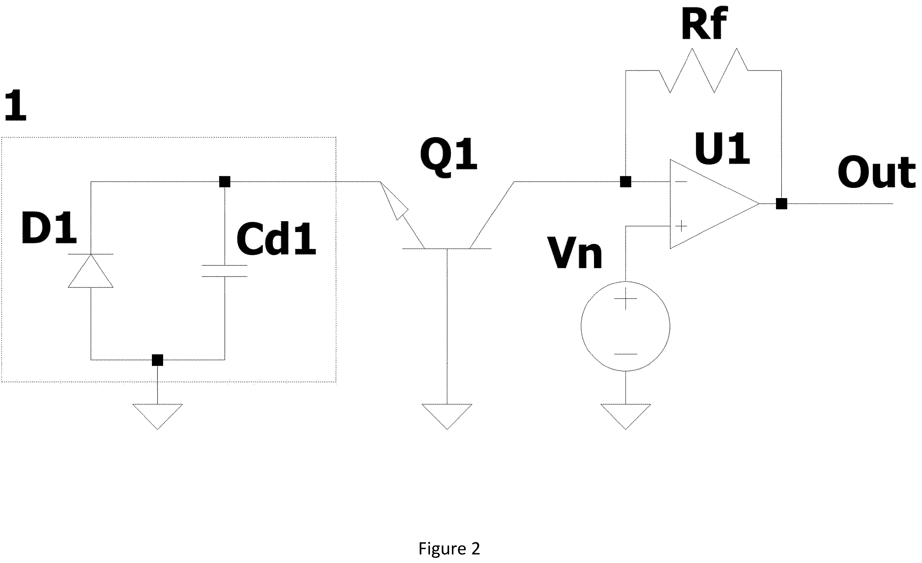

Figure 2 shows an example of a wireless receiver 4 overcoming the problem introduced by the TIA from Figure 1. A transistor Q1 is provided between the output of the photodiode 1 and the negative input of the Op-Amp U1. The emitter of the transistor Q1 is coupled to the input of the photodiode 1. The base of the transistor Q1 is coupled to ground. The collector of the transistor Q1 is coupled to the negative input of the Op-Amp U1. The transistor Q1 provides a low impedance path between the emitter and the base. This causes the parasitic capacitance Cd1 to be shunted by the low impedance path between the emitter and base. This could be interpreted as that the output of the photodiode 1 'sees' a low impedance load. The transistor Q1 also provides a very high impedance between the collector and the base. Therefore, a large impedance is provided between the negative input of the Op-Amp U1 and the ground. The diode D1 provides a current to the emitter of the transistor Q1. The transistor Q1 transmits the current provided to the emitter to the collector. This principle may also be referred to as a 'cascode'. The current is provided to the negative input of the Op-Amp U1. Because of the large impedance between the collector and the base, the current will flow through the feedback resistor Rf to the output of the Op-Amp Out. The Op-Amp will therefore fully regulate for the current provided by the diode D1, while the undesired effects of the parasitic capacitance Cd1 have been neutralized. The noise caused by the Op-Amp, represented at the positive input, will also find no path to the parasitic capacitance Cd1 since the transistor Q1 blocks the path. The only path provided by the transistor Q1 is via the high impedance between the collector and base. This impedance is of such magnitude that the impact is negligible for the feedback of the Op-Amp because in general, the feedback resistance Rf is in the order of kilo Ohms, where the high impedance is in the order of Mega Ohms. The use of a TIA allows the bandwidth of the wireless receiver 4 to be improved and the introduction of the transistor Q1 prevents any noise amplification by the parasitic capacitances. Therefore, the wireless receiver 4 has a higher bandwidth and a lower noise.

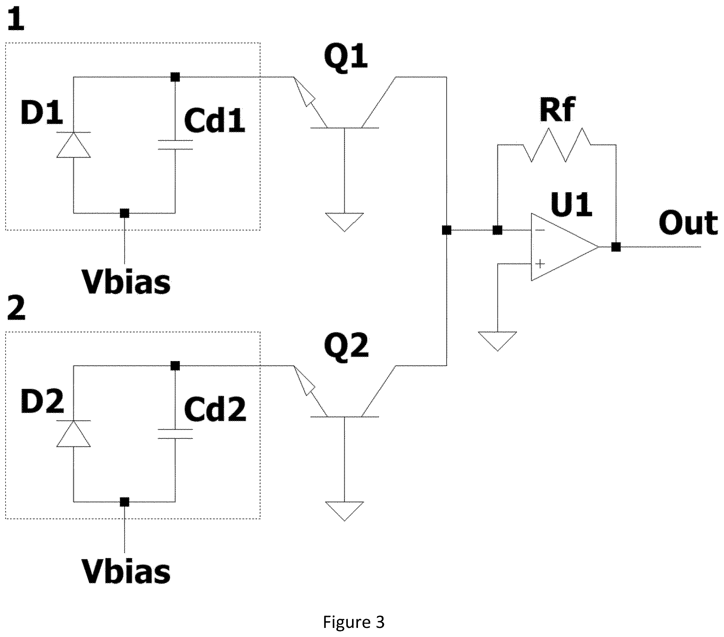

Figure 3 shows an example of a wireless receiver. A first photodiode 1 and a second photodiode 2 are provided. The first photodiode 1 has a first parasitic capacitance Cd1 and a first diode D1 for receiving light and provide a current based on the received light. The first parasitic capacitance Cd1 is shown as a separate capacitor in parallel with the first diode D1. The second photodiode 2 has a second parasitic capacitance Cd2 and a second diode D2 for receiving light and provide a current based on the received light. The second parasitic capacitance Cd2 is shown as a separate capacitor in parallel with the second diode D2. The first photodiode 1 and the second photodiode 2 may be coupled to a bias voltage Vbias at their anode sides. This may be used to provide a bias voltage Vbias to the voltage generated by the photodiode to allow a better voltage matching with the voltage provided at the TIA. The bias voltage Vbias may for example be a ground reference voltage. A negative voltage applied as a bias voltage Vbias allows the photodiodes to be reverse biased, allowing a more efficient conversion of photons into electrons. A first semiconductor switching element Q1 is provided at the output of the first photodiode 1. A second semiconductor switching element Q2 is provided at the output of the second photodiode 2. In this example, the first semiconductor switching element Q1 and the second semiconductor switching element Q2 are shown as bipolar transistors. The emitter of the first transistor Q1 is coupled to the output of the first photodiode 1. The emitter of the second transistor Q2 is coupled to the output of the second photodiode 2. The base of the first transistor Q1 and the base of the second transistor Q2 are coupled to the ground reference. A TIA is provided, which is coupled to the first transistor Q1 and the second transistor Q2. In this example, the TIA has

an Op-Amp U1 having a negative input as a first input and a positive input as a second input. The negative input of the Op-Amp U1 is coupled to the collector of the first transistor Q1 and the collector of the second transistor Q2. The positive input of the Op-Amp U1 is coupled to a reference voltage, which is in this example a ground reference. Between the negative input and the output of the Op-Amp U1 is a feedback resistor Rf that is used as a feedback resistance, which is used for operating the TIA. A capacitor may also be placed across the feedback resistor Rf for additional feedback functionality. The TIA is therefore used to improve the bandwidth of the wireless receiver 4 since the TIA allows a fast signal

processing and removes the undesired effects caused by the first parasitic capacitance Cd1 and the second parasitic capacitance Cd2. A described for the Figures 1 and 2, the TIA amplifies the sensed signals and also any noise that may be generated by the Op-Amp U1 itself because of the undesired interaction between the parasitic capacitances of the photodiodes and the noise source represented at the positive input of the Op-Amp U1. The semiconductor switching elements are provided between the high frequency path, in this case the parasitic capacitances of the photodiodes, for the noise signal provided by the Op-Amp itself and the TIA. This allows a blocking of the noise path effectively preventing any noise from being amplified by the Op-Amp U1, while allowing the signal of the photodiode to be provided to the TIA in an efficient way.

It is an insight of the inventors that this topology can be further improved. If a photodiode is used with a larger sensor surface area for increased sensitivity, the parasitic capacitance will still influence the noise suppression of the circuit. This is because the transistors are not able to provide a perfect shunting of the parasitic capacitance since a low impedance will always be present between the emitter and the base. Increasing the sensor surface area increases the parasitic capacitance and therefore the undesired effects. The inventors propose to use multiple photodiodes instead of one larger photodiode. This allows a similar sensor surface area to be provided as with a single large photodiode. Since each smaller photodiode is coupled to its own semiconductor switching element, each transistor will be exposed to a fraction of the total parasitic capacitance. In the example provided in Figure 3, two photodiodes are provided, each coupled to is corresponding transistor. Each transistor will therefore be exposed to only half of the total parasitic capacitance.

The semiconductor switching elements may be configured to operate as common-base amplifiers.

By using multiple photodiodes as proposed in the invention, the overall sensor surface area of the wireless receiver 4 can be made larger, while reducing the undesired effects caused by the parasitic capacitances. This allows the sensitivity of the wireless receiver 4 to be increased while allowing a high bandwidth and a good noise suppression. Providing all photosensors together, via their corresponding semiconductor switching elements, to a single TIA allows for a simple processing of the received signals of the photodiodes and generate a single signal that can be processed by further circuitry.

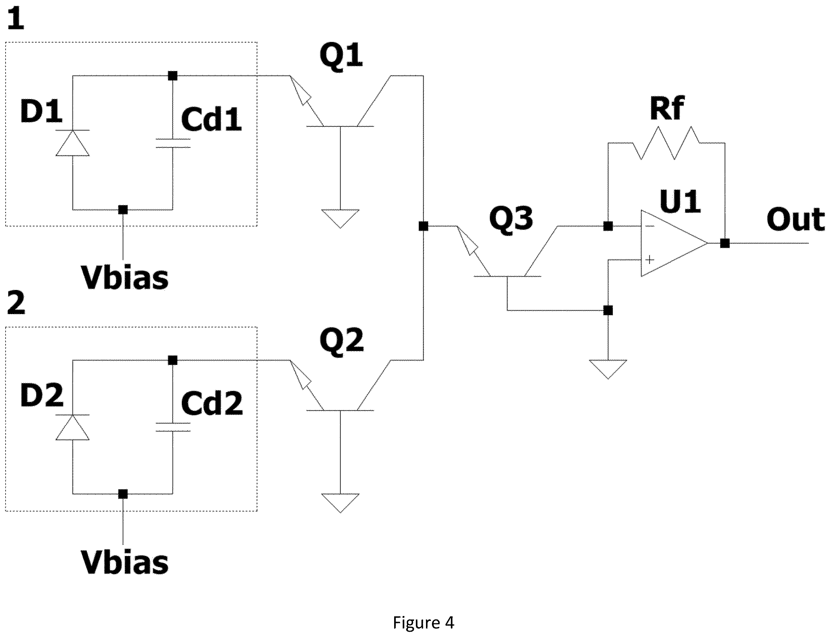

Figure 4 shows another example of a wireless receiver. A first photodiode 1 and a second photodiode 2 are provided. The first photodiode 1 has a first parasitic capacitance Cd1 and a first diode D1 for receiving light. The first parasitic capacitance Cd1 is shown as a separate capacitor in parallel with the first diode D1. The second photodiode 2 has a second parasitic capacitance Cd2 and a second diode D2 for receiving light. The second parasitic capacitance Cd2 is shown as a separate capacitor in parallel with the second diode D2. The first photodiode 1 and the second photodiode 2 may be coupled to a bias voltage Vbias at their anode sides. This may be used to provide a bias voltage Vbias to the voltage generated by the photodiode to allow a better voltage matching with the voltage provided at the TIA. A negative voltage applied as a bias voltage Vbias allows the photodiodes to be reverse biased, allowing a more efficient conversion of photons into electrons. A first semiconductor switching element Q1 is provided at the output of the first photodiode 1. A second semiconductor switching element Q2 is provided at the output of the second photodiode 2. In this example, the first semiconductor switching element Q1 and the second semiconductor switching element Q2 are shown as bipolar transistors. The emitter of the first transistor Q1 is coupled to the output of the first photodiode 1. The emitter of the second transistor Q2 is coupled to the output of the second photodiode 2. The base of the first transistor Q1 and the base of the second transistor Q2 are coupled to the ground reference.

A third semiconductor switching element Q3 is provided in the form of a transistor. The emitter of the third transistor Q3 is coupled to the collector of the first transistor Q1 and the collector of the second transistor Q2. The collector of the third transistor Q3 is coupled to the negative input of the Op-Amp U1. The base of the third transistor Q3 is preferably biased by a bias voltage Vb so that Q3 can work in the linear regime optimally. The Op-Amp U1 and the feedback resistance Rf form part of the TIA. The positive input of the Op-Amp U1 is coupled to a reference voltage, which is in this example a ground reference. Between the negative input and the output of the Op-Amp U1 is a feedback resistor Rf that is used as a feedback resistance, which is used for operating the TIA. A capacitor may also be placed across the feedback resistor Rf for additional feedback functionality. The introduction of the third transistor Q3 allows the design of the wireless receiver 4 to be simplified. It is desired to keep the electric connection between the first transistor Q1 or the second transistor Q2 and the negative input of the Op-Amp U1 as short as possible. Preferably, the first transistor Q1 is located close to the first photodiode 1. Preferably, they may be integrated in the same package or positioned on the same die. Preferably, the second transistor Q2 is located close to the second photodiode 2. Preferably, they may be integrated in the same package or positioned on the same die. The TIA may be located at a different location, far away from the photodiodes. The third transistor Q3 may be placed close to the TIA, allowing the electrical connection between the collector of the third transistor Q3 and the negative input of the Op-Amp to be kept as short as possible. Preferably, the Op-Amp U1 and the third transistor Q3 are integrated on a single die or in a single package. The electrical connection between the emitter of the third transistor Q3 and the collectors of the first transistor Q1 and the second transistor Q2 is now allowed to be longer without an impact in performance, allowing the TIA to be positioned anywhere in the design, e.g. anywhere on the printed circuit board, PCB, to optimize for example, the layout of the traces.

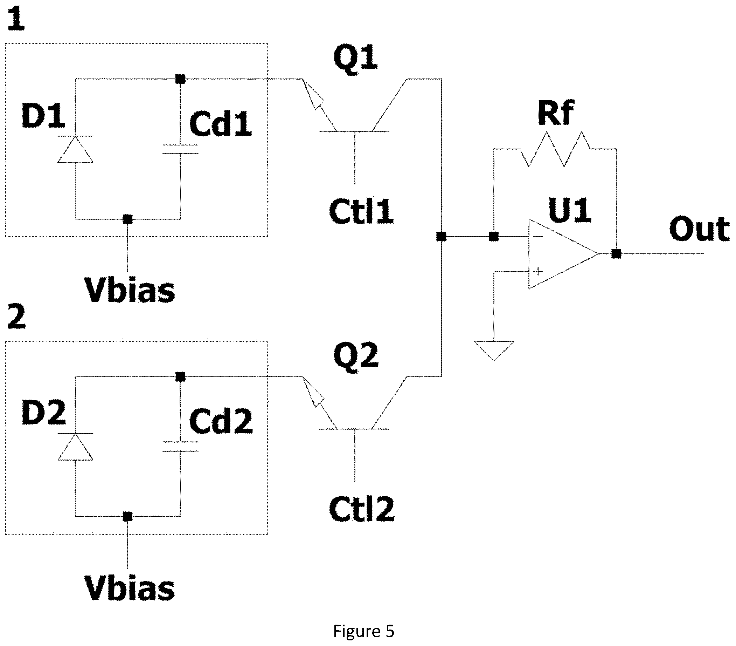

Figure 5 shows another example of a wireless receiver. A first photodiode 1 and a second photodiode 2 are provided. The first photodiode 1 has a first parasitic capacitance Cd1 and a first diode D1 for receiving light. The first parasitic capacitance Cd1 is shown as a separate capacitor in parallel with the first diode D1. The second photodiode 2 has a second parasitic capacitance Cd2 and a second diode D2 for receiving light. The second parasitic capacitance Cd2 is shown as a separate capacitor in parallel with the second diode D2. The first photodiode 1 and the second photodiode 2 may be coupled to a bias voltage Vbias at their anode sides. This may be used to provide a bias voltage Vbias to the voltage generated by the photodiode to allow a better voltage matching with the voltage provided at the TIA. The bias voltage Vbias may for example be a ground reference voltage. A negative voltage applied as a bias voltage Vbias allows the photodiodes to be reverse biased, allowing a more efficient conversion of photons into electrons. A first semiconductor switching element Q1 is provided at the output of the first photodiode 1. A second semiconductor switching element Q2 is provided at the output of the second photodiode 2. In this example, the first semiconductor switching element Q1 and the second semiconductor switching element Q2 are shown as bipolar transistors. The emitter of the first transistor Q1 is coupled to the output of the first photodiode 1. The emitter of the second transistor Q2 is coupled to the output of the second photodiode 2. The base of the first transistor Q1 is provided with a first control signal Ctl1 and the base of the second transistor Q2 is provided with a second control signal Ctl2. A TIA is provided, which is coupled to the first transistor Q1 and the second transistor Q2. In this example, the TIA has an Op-Amp U1 having a negative input as a first input and a positive input as a second input. The negative input of the Op-Amp U1 is coupled to the collector of the first transistor Q1 and the collector of the second transistor Q2. The positive input of the Op-Amp U1 is coupled to a reference voltage, which is in this example a ground reference. Between the negative input and the output of the Op-Amp U1 is a feedback resistor Rf that is used as a feedback resistance, which is used for operating the TIA. A capacitor may also be placed across the feedback resistor Rf for additional feedback functionality. The TIA is therefore used to improve the bandwidth of the wireless receiver 4 since the TIA allows a fast signal processing and removes the undesired effects caused by the first parasitic capacitance Cd1 and the second parasitic capacitance Cd2. A described for the Figures 1 and 2, the TIA amplifies the sensed signals and also any noise that may be generated by the Op-Amp U1 itself because of the undesired interaction between the parasitic capacitances of the photodiodes and the noise source represented at the positive input of the Op-Amp U1. The semiconductor switching elements are provided between the high frequency path, in this case the parasitic capacitances of the photodiodes, for the noise signal provided by the Op-Amp itself and the TIA. This allows a blocking of the noise path effectively preventing any noise from being amplified by the Op-Amp U1, while allowing the signal of the photodiode to be provided to the TIA in an efficient way. By providing a first control signal Ctl1 to the first transistor Q1 and a second control signal Ctl2 to the second transistor Q2, the transistors can be controlled to be opened individually. Opening a transistor causes the corresponding photodiode to be unable to provide any signal to the TIA. A controller may therefore be used to determine which of the photodiodes are to be used or activated such that the wireless receiver 4 can be configured in different ways. As an example, enabling and disabling different photodiodes may allow the wireless receiver 4 to change its sensing orientation. Alternatively, if an application may allow a lower sensitivity, photodiodes may be disconnected. These parasitic capacitances of these disconnected photodiodes will therefore not cause any noise amplification by the TIA effectively reducing the overall noise of the wireless receiver.

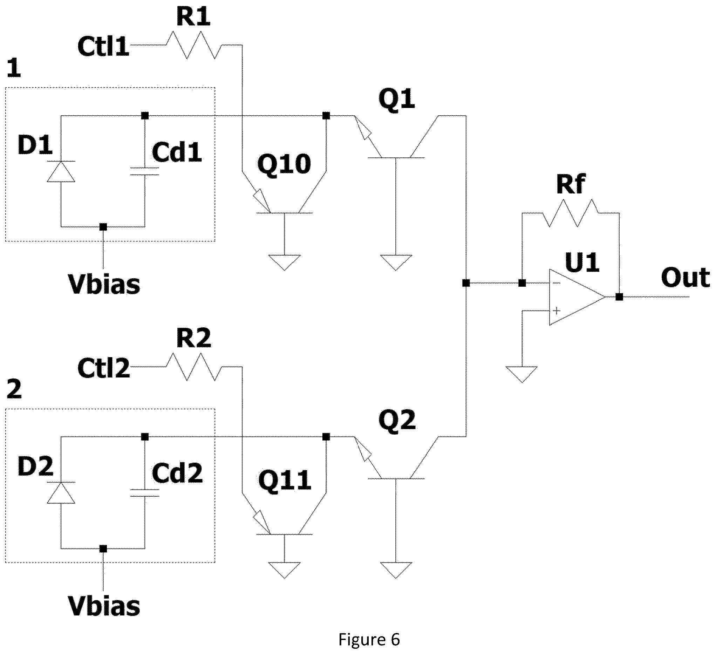

Figure 6 shows another example of a wireless receiver. In addition to components described in Figure 3, additional semiconductor switching elements, in the form of bipolar transistors, in this example, are added. Transistor Q10 can be used to enable or disable the first transistor Q1, hence let the first photodiode D1 current pass through the first transistor Q1, or not. Transistor Q10 is controlled by the control signal Ctl1, that is via resistor R1 connected to the emitter of the transistor Q10. The base of transistor Q10 can be connected to the ground reference, and the collector of transistor Q10 is connected to the emitter of the first transistor Q1. When the control signal Ctl1 is low, in this example equals ground potential, the transistor Q10 has no bias in the base-emitter junction, so it also cannot conduct the current from the base to the collector. With the control signal Ctl1 low, transistor Q10 becomes 'invisible' for the first transistor Q1, so in effect it is as if transistor Q10 is not attached to the first transistor Q1, except for a tiny parasitic collector-base capacitance. When the control signal Ctl1 is high, in this example a couple of volts, the base-emitter junction of transistor Q10 is forward biased and it tends to conduct the current from the emitter to the collector. The collector current of transistor Q10 can only be sunk by the first photodiode D1. If the resistor R1 is dimensioned in such a way that the current through R1 is higher than the highest current expected through the first photodiode D1, then part of the emitter current of the transistor Q10 will flow to its base, saturating transistor Q10. When transistor Q10 is saturated, the collector-emitter voltage will typically be in the order of approximately 100mV, pulling the emitter voltage of the first transistor Q1 above the ground level and reverse biasing the first transistor Q1 in this way. When the first transistor Q1 is reverse biased, its collector cannot conduct current, and it will be effectively disconnected from the input of the TIA. In this way the output of the first photodiode D1 is disconnected from the TIA input, so it does not contribute to the TIA output signal. In this way an additional simple bipolar transistor can effectively enable or disable the contribution of the photodiode current at the TIA input.

Preferably the switching control of the transistors Q1, Q2, Q10 and Q11 is configured to allow the connection of one or more photodiodes to the same TIA input, but to avoid that any photodiode is connect simultaneously to more than one TIA.

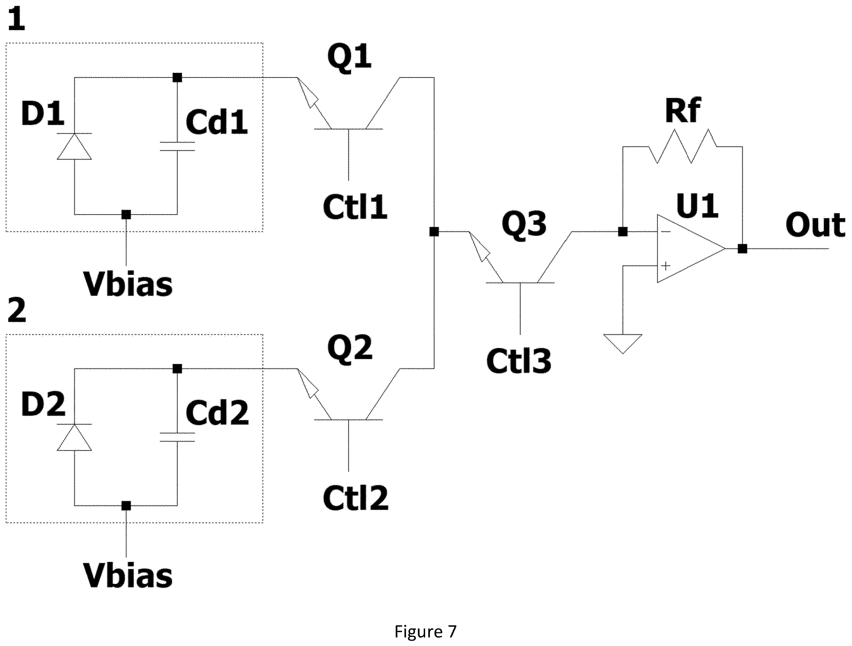

Figure 7 shows another example of a wireless receiver. A first photodiode 1 and a second photodiode 2 are provided. The first photodiode 1 has a first parasitic capacitance Cd1 and a first diode D1 for receiving light. The first parasitic capacitance Cd1 is shown as a separate capacitor in parallel with the first diode D1. The second photodiode 2 has a second parasitic capacitance Cd2 and a second diode D2 for receiving light. The second parasitic capacitance Cd2 is shown as a separate capacitor in parallel with the second diode D2. The first photodiode 1 and the second photodiode 2 may be coupled to a bias voltage Vbias at their anode sides. This may be used to provide a bias voltage Vbias to the voltage generated by the photodiode to allow a better voltage matching with the voltage provided at the TIA. The bias voltage Vbias may for example be a ground reference voltage. A negative voltage applied as a bias voltage Vbias allows the photodiodes to be reverse biased, allowing a more efficient conversion of photons into electrons. A first semiconductor switching element Q1 is provided at the output of the first photodiode 1. A second semiconductor switching element Q2 is provided at the output of the second photodiode 2. In this example, the first semiconductor switching element Q1 and the second semiconductor switching element Q2 are shown as bipolar transistors. The emitter of the first transistor Q1 is coupled to the output of the first photodiode 1. The emitter of the second transistor Q2 is coupled to the output of the second photodiode 2. The base of the first transistor Q1 and the base of the second transistor Q2 are coupled to the ground reference. A TIA is provided, which is coupled to the first transistor Q1 and the second transistor Q2. In this example, the TIA has an Op-Amp U1 having a negative input as a first input and a positive input as a second input. The negative input of the Op-Amp U1 is coupled to the collector of the first transistor Q1 and the collector of the second transistor Q2. The positive input of the Op-Amp U1 is coupled to a reference voltage, which is in this example a ground reference. Between the negative input and the output of the Op-Amp U1 is a feedback resistor Rf that is used as a feedback resistance, which is used for operating the TIA. A capacitor may also be placed across the feedback resistor Rf for additional feedback functionality. The TIA is therefore used to improve the bandwidth of the wireless receiver 4 since the TIA allows a fast signal processing and removes the undesired effects caused by the first parasitic capacitance Cd1 and the second parasitic capacitance Cd2. A described for the Figures 1 and 2, the TIA amplifies the sensed signals and also any noise that may be generated by the Op-Amp U1 itself because of the undesired interaction between the parasitic capacitances of the photodiodes and the noise source represented at the positive input of the Op-Amp U1. The semiconductor switching elements are provided between the high frequency path, in this case the parasitic capacitances of the photodiodes, for the noise signal provided by the Op-Amp itself and the TIA. This allows a blocking of the noise path effectively preventing any noise from being amplified by the Op-Amp U1, while allowing the signal of the photodiode to be provided to the TIA in an efficient way. Similar as shown in Figure 5, a first control signal Ctl1 may be provided to the first transistor Q1 and a second control signal Ctl2 may be provided to the second transistor Q2. This allows the first transistor Q1 and the second transistor Q2 to be controlled to be opened and closed individually. A third semiconductor switching element Q3 is provided in the form of a transistor. The emitter of the third transistor Q3 is coupled to the collector of the first transistor Q1 and the collector of the second transistor Q2. The collector of the third transistor Q3 is coupled to the negative input of the Op-Amp U1. The base of the third transistor Q3 is provided with a third control signal Ctl3. This allows the third transistor Q3 to be controlled to be opened and closed independently of the first transistor Q1 and the second transistor Q2. The opening the third transistor Q3 allows all photodiodes to be disconnected from the TIA. This may be done for energy saving purposes in e.g. a standby mode of the wireless receiver.

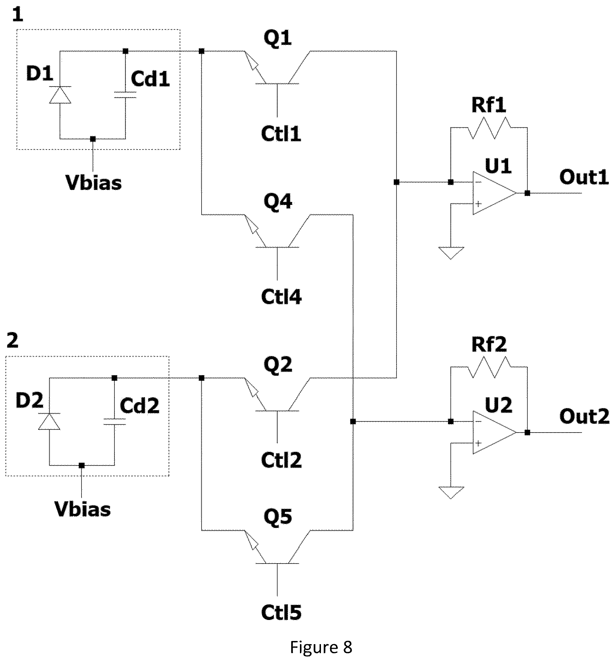

Figure 8 shows another example of a wireless receiver. A first photodiode 1 and a second photodiode 2 are provided. The first photodiode 1 has a first parasitic capacitance Cd1 and a first diode D1 for receiving light. The first parasitic capacitance Cd1 is shown as a separate capacitor in parallel with the first diode D1. The second photodiode 2 has a second parasitic capacitance Cd2 and a second diode D2 for receiving light. The second parasitic capacitance Cd2 is shown as a separate capacitor in parallel with the second diode D2. The first photodiode 1 and the second photodiode 2 may be coupled to a bias voltage Vbias at their anode sides. This may be used to provide a bias voltage Vbias to the voltage generated by the photodiode to allow a better voltage matching with the voltage provided at the TIA. The bias voltage Vbias may for example be a ground reference voltage. A negative voltage applied as a bias voltage Vbias allows the photodiodes to be reverse biased, allowing a more efficient conversion of photons into electrons. A first semiconductor switching element Q1 is provided at the output of the first photodiode 1. A second semiconductor switching element Q2 is provided at the output of the second photodiode 2. In this example, the first semiconductor switching element Q1 and the second semiconductor switching element Q2 are shown as bipolar transistors. The emitter of the first transistor Q1 is coupled to the output of the first photodiode 1. The emitter of the second transistor Q2 is coupled to the output of the second photodiode 2. The base of the first transistor Q1 and the base of the second transistor Q2 are coupled to the ground reference. A TIA is provided, which is coupled to the first transistor Q1 and the second transistor Q2. In this example, the TIA has an Op-Amp U1 having a negative input as a first input and a positive input as a second input. The negative input of the Op-Amp U1 is coupled to the collector of the first transistor Q1 and the collector of the second transistor Q2. The positive input of the Op-Amp U1 is coupled to a reference voltage, which is in this example a ground reference. Between the negative input and the output of the Op-Amp U1 is a feedback resistor Rf1 that is used as a feedback resistance, which is used for operating the TIA. A capacitor may also be placed across the feedback resistor Rf1 for additional feedback functionality. The TIA is therefore used to improve the bandwidth of the wireless receiver 4 since the TIA allows a fast signal processing and removes the undesired effects caused by the first parasitic capacitance Cd1 and the second parasitic capacitance Cd2. As described for the Figures 1 and 2, the TIA amplifies the sensed signals and also any noise that may be generated by the Op-Amp U1 itself because of the undesired interaction between the parasitic capacitances of the photodiodes and the noise source represented at the positive input of the Op-Amp U1. The semiconductor switching elements are provided between the high frequency path, in this case the parasitic capacitances of the photodiodes, for the noise signal provided by the Op-Amp itself and the TIA. This allows a blocking of the noise path effectively preventing any noise from being amplified by the Op-Amp U1, while allowing the signal of the photodiode to be provided to the TIA in an efficient way.

A fourth semiconductor switching element Q4 is provided in the form of a transistor and a fifth semiconductor switching element Q5 is provided in the form of a transistor. The emitter of the fourth transistor Q4 is coupled to the output of the first photodiode 1. The emitter of the fifth transistor Q5 is coupled to the output of the second photodiode 2. The base of the fourth transistor Q4 is provided with a fourth control signal Ctl4. The base of the fifth transistor Q5 is provided with a fifth control signal Ctl5. This allows both the fourth transistor Q4 and the fifth transistor Q5 to be turned on and off by the corresponding control signals. Preferably, the transistors can be controlled independently.

A second TIA is provided, which is coupled to the fourth transistor Q4 and the fifth transistor Q5. In this example, the TIA has an Op-Amp U2 having a negative input as a first input and a positive input as a second input. The negative input of the Op-Amp U2 is coupled to the collector of the fourth transistor Q4 and the collector of the fifth transistor Q5. The positive input of the Op-Amp U2 is coupled to a reference voltage, which is in this example a ground reference. Between the negative input and the output of the Op-Amp U2 is a feedback resistor Rf2 that is used as a feedback resistance, which is used for operating the TIA. A capacitor may also be placed across the feedback resistor Rf for additional feedback functionality. As can be seen in Figure 8, the photodiodes can now be coupled to two different TIA's. This allows a user to switch to where the sensed signal is to be sent to. As an example, the wireless receiver 4 may be provided as a standalone unit with multiple outputs. The wireless receiver 4 may be configured to switch between a first configuration, where the first TIA is used, to a second configuration, where the second TIA is used.

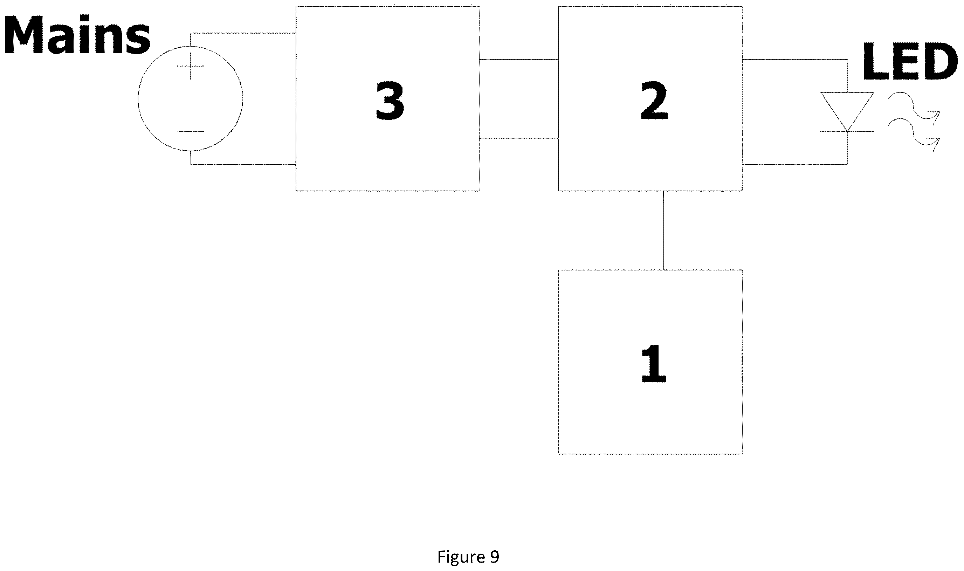

Figure 9 shows an example of a circuit diagram of a system for optical communication. The system may be coupled to a standard mains voltage Mains. A rectifier circuit 3 may be used to rectify the mains voltage and provide a rectifier voltage. The rectified voltage may be provided to a driver 2 for driving a load LED. The driver 2 may be arranged to provide a regulated current to the load LED. The load LED is preferably a lighting load. The lighting load LED is preferably a semiconductor lighting load. Examples of semiconductor lighting loads are LEDs, laser diodes and vertical-cavity surface-emitting lasers. The lighting load is therefore arranged to allow light to be emitted at a high pulse frequency, allowing an optical communication to be established with another device. To receive optical data, the system may further comprise a wireless receiver 4 according to the invention. This allows the system to receive optical data at a high sensitivity, with a high bandwidth and a low noise. The system allows a bi-directional communication with another device or system with an improved overall performance.

In the examples provided, the second input of the Op-Amp U1 is coupled to a ground reference. The second input of the Op-Amp U1 may also be coupled to a reference voltage larger or lower than the ground reference to allow the TIA to operate in the linear regime.

In the examples provided, the ground reference or ground reference voltage may be considered a voltage of 0 V compared to the other voltage level present in the circuits.

In the examples, the bias voltage is shown as a separate voltage from other voltages. For simplicity, the bias voltage Vbias may be identical to the ground voltage provided at the base of the semiconductor switching elements.

In the examples provided, the semiconductor switching elements are shows as bipolar transistors. The transistor may be also considered of the MOSFET type. Instead of a common base topology, the circuit with a MOSFET may be configured as a common gate topology allowing a MOSFET to also achieve the desired effects of the invention.

In the examples provided, the semiconductor switching elements may be opened and closed as to provide or prevent a connection between the photodiode and the TIA. Preferably, a controller may determine based on the quality of the light signal to the photodiodes which photodiodes are to be connected to the TIA and which not. As an example, it may be that some photodiodes may not receive enough light to provide a proper contribution to the overall sensed light. The controller may then determine to disconnect the corresponding one or more photodiodes. The parasitic capacitances of the photodiodes will then not contribute to genertaed noise.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A wireless receiver (4) for optical communication, the wireless receiver comprising:
- a first photodiode (1);
- a first semiconductor switching element (Q1) comprising a first connection and a second connection, wherein the first connection of the first semiconductor switching element (Q1) is coupled to an output of the first photodiode (1);
- a second photodiode (2);
- a second semiconductor switching element (Q2) comprising a first connection and a second connection, wherein the first connection of the second semiconductor switching element (Q2) is coupled to an output of the second photodiode (2);
- a transimpedance amplifier, TIA, comprising a first input, wherein the second connection of the first semiconductor switching element (Q1) and the second connection of the second semiconductor switching element (Q2) are coupled to the first input of the TIA,
**characterized in that** the TIA further comprises a third semiconductor switching element (Q3) and an operational amplifier (U1), wherein the third semiconductor (Q3) is coupled between the first input of the TIA and an input of the operational amplifier (U1) and wherein a second input of the TIA is coupled to a second input of the operational amplifier (U1).

2. The wireless receiver (4) of claim 1, wherein the first semiconductor switching element (Q1) is adapted to operate in a linear operating mode in which it shows a low impedance on the first connection to the first photodiode (1) and a high impedance on the second connection to the TIA.

3. The wireless receiver (4) of claim 2, wherein the first semiconductor switching element (Q1) is a bipolar transistor wherein:
- an emitter of the bipolar transistor is coupled to the first photodiode (1);
- a collector of the bipolar transistor is coupled to the first input of the TIA;
- a base of the bipolar transistor is coupled to a reference voltage.

4. The wireless receiver (4) according to any of the preceding claims, wherein the first semiconductor switching element (Q1) comprises a control connection and wherein the second semiconductor switching element (Q2) comprises a control connection, wherein:
- the control connection of the first semiconductor switching element (Q1) and the control connection of the second semiconductor switching element (Q2) are coupled to the reference voltage, and/or
- the control connection of the first semiconductor switching element (Q1) is adapted to receive a first control signal and the control connection of the second semiconductor switching element (Q2) is adapted to receive a second control signal.

5. The wireless receiver (4) of claim 4, when the control connection of the first semiconductor switching element (Q1) is adapted to receive the first control signal and the control connection of the second semiconductor switching element (Q2) is adapted to receive the second control signal, wherein the first control signal and the second control signal are provided to couple or decouple the first photodiode (1) and/or the second photodiode (2) to or from the first input of the TIA.

6. The wireless receiver (4) according to any of the preceding claims, wherein a reference voltage is applied to the second input.

7. The wireless receiver (4) according to any of the preceding claims, wherein the operational amplifier (U1) and the third semiconductor switching element (Q3) are integrated on a single die or integrated in a single package.

8. The wireless receiver (4) according to any of the preceding claims, wherein the third semiconductor switching element (Q3) is a bipolar transistor adapted to operate in a linear operating mode.

9. The wireless receiver (4) according to any of the preceding claims, where the first photodiode (1) and the first semiconductor switching element (Q1) are integrated on a single die or integrated in a single package.

10. A system for optical communication, the system comprising:
- the wireless receiver (4) according to any of the preceding claims;
- a driver (2) adapted to receive an input power at an input of the driver (2) and provide a regulated output power at an output of the driver (2);
- a load coupled to the output of the driver (LED).

11. The system according to claim 10, wherein the load (LED) is a lighting load and wherein the system is a lighting system.

12. The system according to claim 11, wherein the lighting load comprises a semiconductor lighting element.

13. The system according to any of the claims 10 to 12, wherein the regulated output power is controlled based on information received by the wireless receiver (4).

14. The system according to any of the claims 11 to 13, wherein the driver (2) is adapted to provide a pulsed current to the load (LED) such that the system is arranged to provide optical communication.

## Patentansprüche

1. Drahtloser Empfänger (4) für eine optische Kommunikation, der drahtlose Empfänger umfassend:
- eine erste Fotodiode (1);
- ein erstes Halbleiterschaltelement (Q1), umfassend eine erste Verbindung und eine zweite Verbindung, wobei die erste Verbindung des ersten Halbleiterschaltelements (Q1) mit einem Ausgang der ersten Fotodiode (1) gekoppelt ist;
- eine zweite Fotodiode (2);
- ein zweites Halbleiterschaltelement (Q2), umfassend eine erste Verbindung und eine zweite Verbindung, wobei die erste Verbindung des zweiten Halbleiterschaltelements (Q2) mit einem Ausgang der zweiten Fotodiode (2) gekoppelt ist;
- einen Transimpedanzverstärker, TIA, umfassend einen ersten Eingang, wobei die zweite Verbindung des ersten Halbleiterschaltelements (Q1) und die zweite Verbindung des zweiten Halbleiterschaltelements (Q2) mit dem ersten Eingang des TIA gekoppelt sind,
**dadurch gekennzeichnet, dass** der TIA ferner ein drittes Halbleiterschaltelement (Q3) und einen Betriebsverstärker (U1) umfasst, wobei der dritte Halbleiter (Q3) zwischen dem ersten Eingang des TIA und einem Eingang des Betriebsverstärkers (U1) gekoppelt ist und wobei ein zweiter Eingang des TIA mit einem zweiten Eingang des Betriebsverstärkers (U1) gekoppelt ist.

2. Drahtloser Empfänger (4) nach Anspruch 1, wobei das erste Halbleiterschaltelement (Q1) angepasst ist, um in einem linearen Betriebsmodus betrieben zu werden, in dem es eine niedrige Impedanz an der ersten Verbindung zu der ersten Fotodiode (1) und eine hohe Impedanz an der zweiten Verbindung zu dem TIA vorweist.

3. Drahtloser Empfänger (4) nach Anspruch 2, wobei das erste Halbleiterschaltelement (Q1) ein Bipolartransistor ist, wobei:
- ein Emitter des Bipolartransistors mit der ersten Fotodiode (1) gekoppelt ist;
- ein Kollektor des Bipolartransistors mit dem ersten Eingang des TIA gekoppelt ist;
- eine Basis des Bipolartransistors mit einer Referenzspannung gekoppelt ist.

4. Drahtloser Empfänger (4) nach einem der vorstehenden Ansprüche, wobei das erste Halbleiterschaltelement (Q1) eine Steuerverbindung umfasst und wobei das zweite Halbleiterschaltelement (Q2) eine Steuerverbindung umfasst, wobei:
- die Steuerverbindung des ersten Halbleiterschaltelements (Q1) und die Steuerverbindung des zweiten Halbleiterschaltelements (Q2) mit der Referenzspannung gekoppelt sind, und/oder
- die Steuerverbindung des ersten Halbleiterschaltelements (Q1) angepasst ist, um ein erstes Steuersignal zu empfangen, und die Steuerverbindung des zweiten Halbleiterschaltelements (Q2) angepasst ist, um ein zweites Steuersignal zu empfangen.

5. Drahtloser Empfänger (4) nach Anspruch 4, wenn die Steuerverbindung des ersten Halbleiterschaltelements (Q1) angepasst ist, um das erste Steuersignal zu empfangen, und die Steuerverbindung des zweiten Halbleiterschaltelements (Q2) angepasst ist, um das zweite Steuersignal zu empfangen, wobei das erste Steuersignal und das zweite Steuersignal bereitgestellt sind, um die erste Fotodiode (1) und/oder die zweite Fotodiode (2) mit dem ersten Eingang des TIA zu koppeln oder davon zu entkoppeln.

6. Drahtloser Empfänger (4) nach einem der vorstehenden Ansprüche, wobei eine Referenzspannung an den zweiten Eingang angelegt wird.

7. Drahtloser Empfänger (4) nach einem der vorstehenden Ansprüche, wobei der Betriebsverstärker (U1) und das dritte Halbleiterschaltelement (Q3) auf einem einzigen Die integriert oder in einem einzigen Gehäuse integriert sind.

8. Drahtloser Empfänger (4) nach einem der vorstehenden Ansprüche, wobei das dritte Halbleiterschaltelement (Q3) ein Bipolartransistor ist, der angepasst ist, um in einem linearen Betriebsmodus betrieben zu werden.

9. Drahtloser Empfänger (4) nach einem der vorstehenden Ansprüche, wobei die erste Fotodiode (1) und das erste Halbleiterschaltelement (Q1) auf einem einzigen Die integriert oder in einem einzigen Gehäuse integriert sind.

10. System für die optische Kommunikation, das System umfassend:
- den drahtlosen Empfänger (4) nach einem der vorstehenden Ansprüche;
- einen Treiber (2), der angepasst ist, um eine Eingangsleistung an einem Eingang des Treibers (2) zu empfangen und eine geregelte Ausgangsleistung an einem Ausgang des Treibers (2) bereitzustellen;
- eine Last, die mit dem Ausgang des Treibers (LED) gekoppelt ist.

11. System nach Anspruch 10, wobei die Last (LED) eine Beleuchtungslast ist und wobei das System ein Beleuchtungssystem ist.

12. System nach Anspruch 11, wobei die Beleuchtungslast ein Halbleiterbeleuchtungselement umfasst.

13. System nach einem der Ansprüche 10 bis 12, wobei die geregelte Ausgangsleistung basierend auf Informationen gesteuert wird, die durch den drahtlosen Empfänger (4) empfangen werden.

14. System nach einem der Ansprüche 11 bis 13, wobei der Treiber (2) angepasst ist, um einen gepulsten Strom an die Last (LED) derart bereitzustellen, dass das System eingerichtet ist, um die optische Kommunikation bereitzustellen.

## Revendications

1. Récepteur sans fil (4) pour communication optique, le récepteur sans fil comprenant :
- une première photodiode (1) ;
- un premier élément de commutation à semi-conducteur (Q1) comprenant une première connexion et une seconde connexion, dans lequel la première connexion du premier élément de commutation à semi-conducteur (Q1) est couplée à une sortie de la première photodiode (1) ;
- une seconde photodiode (2) ;
- un deuxième élément de commutation à semi-conducteur (Q2) comprenant une première connexion et une seconde connexion, dans lequel la première connexion du deuxième élément de commutation à semi-conducteur (Q2) est couplée à une sortie de la seconde photodiode (2) ;
- un amplificateur à transimpédance, TIA, comprenant une première entrée, dans lequel la seconde connexion du premier élément de commutation à semi-conducteur (Q1) et la seconde connexion du deuxième élément de commutation à semi-conducteur (Q2) sont couplées à la première entrée du TIA,
**caractérisé en ce que** le TIA comprend en outre un troisième élément de commutation à semi-conducteur (Q3) et un amplificateur opérationnel (U1), dans lequel le troisième semi-conducteur (Q3) est couplé entre la première entrée du TIA et une entrée de l'amplificateur opérationnel (U1) et dans lequel une seconde entrée du TIA est couplée à une seconde entrée de l'amplificateur opérationnel (U1).

2. Récepteur sans fil (4) selon la revendication 1, dans lequel le premier élément de commutation à semi-conducteur (Q1) est conçu pour fonctionner dans un mode de fonctionnement linéaire dans lequel il présente une faible impédance sur la première connexion à la première photodiode (1) et une impédance élevée sur la seconde connexion au TIA.

3. Récepteur sans fil (4) selon la revendication 2, dans lequel le premier élément de commutation à semi-conducteur (Q1) est un transistor bipolaire, dans lequel :
- un émetteur du transistor bipolaire est couplé à la première photodiode (1) ;
- un collecteur du transistor bipolaire est couplé à la première entrée du TIA ;
- une base du transistor bipolaire est couplée à une tension de référence.

4. Récepteur sans fil (4) selon l'une quelconque des revendications précédentes, dans lequel le premier élément de commutation à semi-conducteur (Q1) comprend une connexion de commande et dans lequel le deuxième élément de commutation à semi-conducteur (Q2) comprend une connexion de commande, dans lequel :
- la connexion de commande du premier élément de commutation à semi-conducteur (Q1) et la connexion de commande du deuxième élément de commutation à semi-conducteur (Q2) sont couplées à la tension de référence, et/ou
- la connexion de commande du premier élément de commutation à semi-conducteur (Q1) est conçue pour recevoir un premier signal de commande et la connexion de commande du deuxième élément de commutation à semi-conducteur (Q2) est conçue pour recevoir un second signal de commande.

5. Récepteur sans fil (4) selon la revendication 4, lorsque la connexion de commande du premier élément de commutation à semi-conducteur (Q1) est conçue pour recevoir le premier signal de commande et que la connexion de commande du deuxième élément de commutation à semi-conducteur (Q2) est conçue pour recevoir le second signal de commande, dans lequel le premier signal de commande et le second signal de commande sont fournis pour coupler ou découpler la première photodiode (1) et/ou la seconde photodiode (2) à la première entrée du TIA ou de celle-ci.

6. Récepteur sans fil (4) selon l'une quelconque des revendications précédentes, dans lequel une tension de référence est appliquée à la seconde entrée.

7. Récepteur sans fil (4) selon l'une quelconque des revendications précédentes, dans lequel l'amplificateur opérationnel (U1) et le troisième élément de commutation à semi-conducteur (Q3) sont intégrés sur une seule puce ou intégrés dans un seul boîtier.

8. Récepteur sans fil (4) selon l'une quelconque des revendications précédentes, dans lequel le troisième élément de commutation à semi-conducteur (Q3) est un transistor bipolaire conçu pour fonctionner dans un mode de fonctionnement linéaire.

9. Récepteur sans fil (4) selon l'une quelconque des revendications précédentes, dans lequel la première photodiode (1) et le premier élément de commutation à semi-conducteur (Q1) sont intégrés sur une seule puce ou intégrés dans un seul boîtier.

10. Système de communication optique, ledit système comprenant :
- le récepteur sans fil (4) selon l'une quelconque des revendications précédentes ;
- un circuit d'attaque (2) conçu pour recevoir une puissance d'entrée au niveau d'une entrée du circuit d'attaque (2) et fournir une puissance de sortie régulée au niveau d'une sortie du circuit d'attaque (2) ;
- une charge couplée à la sortie du circuit d'attaque (DEL).

11. Système selon la revendication 10, dans lequel la charge (DEL) est une charge d'éclairage et dans lequel le système est un système d'éclairage.

12. Système selon la revendication 11, dans lequel la charge d'éclairage comprend un élément d'éclairage à semi-conducteur.

13. Système selon l'une quelconque des revendications 10 à 12, dans lequel la puissance de sortie régulée est commandée sur la base d'informations reçues par le récepteur sans fil (4).

14. Système selon l'une quelconque des revendications 11 à 13, dans lequel le circuit d'attaque (2) est conçu pour fournir un courant pulsé à la charge (DEL) de manière que le système soit agencé pour fournir une communication optique.
